# EUROPÄISCHE PATENTSCHRIFT

(11) **EP 3 183 783 B1**
(45) Veröffentlichungstag und Bekanntmachung des Hinweises auf die Patenterteilung: **23.12.2020**
(21) Anmeldenummer: 15770788.6
(22) Anmeldetag: 17.08.2015
(51) Int. Cl.: H01S 3/00, B23K 26/0622, H01S 5/00, H01S 3/11

(54) **ANORDNUNG UND VERFAHREN ZUM MODULIEREN VON LASERPULSEN**
SYSTEM AND METHOD OF MODULATING LASER PULSES
SYSTÈME ET PROCÉDÉ DE MODULATION D'IMPULSIONS LASER

(30) Priorität: 18.08.2014 DE 102014111774
(43) Veröffentlichungstag der Anmeldung: 28.06.2017
(73) Patentinhaber: AMPHOS GmbH, 52134 Herzogenrath (DE); AMOtronics UG, 52072 Aachen (DE)
(72) Erfinder: DOLKEMEYER, Jan, 52134 Herzogenrath (DE); SCHNITZLER, Claus, 52134 Herzogenrath (DE); MANS, Torsten, 52134 Herzogenrath (DE); VERSE, Stefan, 52080 Aachen (DE); HESSING, Martin, 52074 Aachen (DE); MARTINI, Jürgen, 52064 Aachen (DE)
(74) Vertreter: Feder Walter Ebert
(86) Internationale Anmeldenummer: PCT/DE2015/100341
(87) Internationale Veröffentlichungsnummer: WO 2016/026484

(56) Entgegenhaltungen:
- EP-A1- 2 775 619
- EP-A2- 1 384 293
- US-A- 3 783 406
- US-A1- 2003 007 526
- US-A1- 2005 047 454
- US-A1- 2006 045 150

## Beschreibung

Die Erfindung betrifft eine Anordnung und ein Verfahren zum Modulieren von Laserpulsen mit einem elektro-optischen Modulator, der über eine gepulste Modulationsspannung betrieben wird.

Anordnungen dieser Art sowie die entsprechenden Verfahren finden vor allem im Bereich der Materialbearbeitung mit Laserstrahlung, beispielsweise im Rahmen von Abtragungs- oder Modifikationsprozessen in der Druckindustrie, beim Perforieren von Folien und anderen Prozessen industrielle Anwendung. Aber auch in der Messtechnik und der Grundlagenforschung finden sich verschiedene Anwendungen. Über den Laser wird dabei ein gepulster Laserstrahl bereitgestellt, dessen einzelne Pulse entsprechend den Anforderungen der jeweiligen Anwendung moduliert werden müssen.

Je nachdem, für welche Anwendung der Laser eingesetzt wird, kann es nämlich erforderlich sein, dass die Intensität eines oder mehrerer Laserpulse verändert werden muss. Auch kann es sein, dass nur bestimmte Laserpulse aus dem System heraus gelenkt werden sollen. Hierzu ist es bekannt, die von dem Laser bereitgestellten Laserpulse entsprechend der jeweiligen Anwendung über einen im Strahlweg des Lasers angeordneten Modulator zu modulieren bzw. aufzubereiten.

Als Modulatoren werden in der Regel elektro-optische Modulatoren wie beispielsweise Pockelszellen vorgesehen, die eingangsseitig mit einer elektrischen Modulationsspannung beaufschlagt werden und ausgangsseitig eine optische Modulation der Laserpulse in Phase, Polarisation bzw. Intensität ermöglichen.

Um einzelne oder mehrere Laserpulse gemäß einer entsprechenden Modulationsvorgabe gezielt modulieren zu können, ist es erforderlich, dass auch die Modulationsspannung gepulst ist. Die Modulationsspannung liegt darüber hinaus üblicherweise auf einem vergleichsweise hohen zumeist sogar im Hochspannungsbereich (HV) liegenden Spannungsniveau, wodurch sich Probleme insbesondere bei der Erzeugung sehr kurzer Modulationspulse der Modulationsspannung ergeben können. Denn die Modulationsspannung wird in der Regel als kontinuierliche Spannung von einer Hochspannungsquelle bereit gestellt und durch Betätigung eines nachgeschalteten Hochspannungsschalters entsprechend der Modulationsvorgabe in eine gepulste Spannung überführt.

Problematisch bei solchen bekannten Anordnungen ist jedoch, dass diese insbesondere im Falle kurzer Schaltzeiten einen insgesamt aufwändigen Aufbau aufweisen und sich aufgrund der baulichen Gegebenheiten der Hochspannungsschalter die Schaltzeiten auch nicht beliebig verringern lassen.

Dies hat sich insbesondere bei der Modulation von Laserpulsen in Ultrakurzpulslasersystemen wie etwa Femtosekundenlasern mit hohen Repetitionsraten als nachteilig herausgestellt. Der Grund hierfür ist, dass die Hochspannungsschalter systembedingt eine gewisse Schaltzeit benötigen, um eine Spannung von einem ersten Spannungsniveau auf ein zweites Spannungsniveau umzuschalten. Diese auch als Anstiegszeit bezeichneten Schaltzeiten sind bei Ultrakurzpulslasersystemen nämlich häufig größer als die Pausenzeit zwischen den einzelnen Laserpulsen. Durch die zu lang andauernden Anstiegszeiten kann es daher zu Fehlmodulationen einzelner oder mehrerer Laserpulse kommen, was beispielsweise in der Materialbearbeitung zu unerwünschten Beeinträchtigungen des Bearbeitungsergebnisses führen kann. Auch ist eine pulsgenaue Einstellung jedes Laserpulses während des Bearbeitungsprozesses nicht möglich.

US 2005/047454 A1 offenbart eine Anordnung zum Modulieren von Laserpulsen, die von einem Lasergerät emittiert sind. Diese Anordnung enthält einen elektro-optischen Modulator, der über eine gepulste Modulationsspannung betrieben wird und dem ein Verstärker als Spannungswandler vorgeschaltet ist, der eine auf einem Ausgangsspannungsniveau liegende gepulste Schaltspannung in die gegenüber dem Ausgangsspannungsniveau erhöhte Modulationsspannung wandelt

Die vorliegende Erfindung stellt sich daher die **Aufgabe** , eine Anordnung wie auch ein Verfahren anzugeben, mit welchen es auf einfache Weise möglich ist, eine wenig fehleranfällige Modulation von Laserpulsen auch in Ultrakurzpulslasersystemen vorzunehmen.

Gelöst wird diese Aufgabe bei einer Anordnung der eingangs genannten Art durch einen dem Modulator vorgeschalteten Spannungswandler, der eine auf einem Ausgangsspannungsniveau liegende gepulste Schaltspannung in die gegenüber dem Ausgangsspannungsniveau erhöhte Modulationsspannung wandelt, und durch die weiteren Merkmale, die in Anspruch 1 definiert sind.

Das korrespondierende erfindungsgemäße Verfahren ist in Anspruch 10 definiert.

Bei einer solchen Anordnung kann zunächst eine Schaltspannung auf einem vergleichsweise niedrigen Ausgangsspannungsniveau entsprechend der gewünschten Modulationsvorgabe erzeugt und anschließend über den Spannungswandler unter Beibehaltung der auf dem Ausgangsspannungsniveau erzeugten Pulsfolge in die gegenüber dem Ausgangsspannungsniveau erhöhte Modulationsspannung gewandelt werden. Die Schaltspannung lässt sich auf dem Ausgangsspannungsniveau auf einfachere Weise und mit kürzeren Schaltzeiten schalten. Da die Pulsfolge der Schaltspannung auch nach deren Wandlung durch den Spannungswandler erhalten bleibt, ergeben sich auch auf dem höheren Spannungsniveau der Modulationsspannung kurze Anstiegszeiten. Die Gefahr von Fehlmodulationen auch in Ultrakurzpulslasersystemen wird auf einfache Weise deutlich verringert.

Gemäß einer vorteilhaften Ausgestaltung ist der Spannungswandler als Transformator ausgebildet. Durch die Ausführung als Transformator kann auf einfache Art und Weise ein Spannungswandler realisiert werden. Bei einem Transformator sind die primär- und sekundärseitigen Stromkreise voneinander galvanisch getrennt, was insbesondere unter Sicherheitsaspekten von Vorteil ist. Besonders bevorzugt kann der Transformator einen Transformatorkern aufweisen, wodurch ein höherer Wirkungsgrad erreicht werden kann. Alternativ kann der Spannungswandler auch beispielsweise als Hochsetzsteller ausgebildet sein.

Dem Spannungswandler ist ein Pulserzeuger, insbesondere ein modulierender Pulserzeuger, vorgeschaltet. Durch die Vorschaltung des Pulserzeugers vor den Spannungswandler kann bereits auf dem Ausgangsspannungsniveau, welches bevorzugt im Niederspannungsbereich liegt, eine gepulste Schaltspannung erzeugt werden. Die Verwendung von Niederspannungsbauteilen ermöglicht einen kostengünstigen Aufbau der Anordnung.

Von besonderem Vorteil ist eine Ausgestaltung, bei welcher der Pulserzeuger als Schalter, insbesondere als Halbleiter-Schalter, ausgebildet ist. Besonders bevorzugt ist der Schalter als Transistor ausgebildet. Durch die Verwendung eines Halbleiter-Schalters bzw. eines Transistors kann auf einfache Art und Weise ein schneller Schalter realisiert werden, welcher ohne mechanische Bewegungen elektrische Spannungen schalten kann. Mechanische Abnutzungseffekte und daraus resultierende Verschlechterungen der Anordnung können so vermieden werden. Halbleiter-Schalter bzw. Transistoren weisen sehr kurze Anstiegszeiten auf, so dass das für die genaue Modulation erforderliche schnelle Schalten möglich ist. Mögliche Transistorausgestaltungen können beispielsweise Bipolartransistoren oder Feldeffekttransistoren sein. Besonders bevorzugt ist jedoch die Verwendung von MOSFETs als Pulserzeuger.

In diesem Zusammenhang ist es ferner von Vorteil, wenn der Pulserzeuger als Halbleiter-Halbbrücke oder als Halbleiter-Vollbrücke ausgebildet ist. Besonders bevorzugt können die Halbleiter-Halbbrücke oder die Halbleiter-Vollbrücke als Transistor-Halbbrücke oder Transistor-Vollbrücke ausgestaltet sein. Solche Halb- oder Vollbrücken zeichnen sich dadurch aus, dass nur geringere Schaltverluste während des Umschaltens auftreten, wodurch sich ein günstiger Wirkungsgrad ergibt. Zudem können kurze Anstiegs- bzw. Umschaltzeiten erreicht werden.

Eine weitere vorteilhafte Ausgestaltung sieht vor, dass dem Pulserzeuger eine Niederspannungsquelle vorgeschaltet ist. Durch die Speisung des Pulserzeugers mit einer Niederspannung ergibt sich der Vorteil, dass Niederspannungsbauteile verwendet werden können. Hierdurch kann gegenüber den im Stand der Technik zumeist verwendeten Hochspannungsbauteilen ein Sicherheitsvorteil erreicht werden, da beispielsweise die Überschlagsgefahr aber auch die elektromagnetischen Beeinträchtigungen verringert werden können. Vorteilhafterweise weist die Niederspannungsquelle eine Spannung zwischen 10 V und 1.000 V auf, besonders vorteilhaft zwischen 10 V und 250 V, besonders bevorzugt jedoch eine Spannung von etwa 100 V auf.

In weiterer Ausgestaltung der Erfindung wird vorgeschlagen, dass der Pulserzeuger über eine von einer Steuereinheit erzeugte Steuerspannung ansteuerbar ist. Durch die Ansteuerung des Pulserzeugers über eine Steuerspannung kann die bevorzugt im Niederspannungsbereich liegende Schaltspannung entsprechend einer beispielsweise durch die Art eines Materialbearbeitungsprozesses vorgegebene Modulationsvorgabe, beispielsweise über einen vorgegebenen Bitstrom, moduliert werden. So kann über die Steuerspannung eine gepulste Schaltspannung entsprechend den Modulationsvorgaben der jeweiligen Anwendung, beispielsweise in der Materialbearbeitung erzeugt und anschließend unter Beibehaltung dieser Modulation über den Spannungswandler auf das erforderliche Spannungsniveau der Modulationsspannung gewandelt werden. Über die Steuerspannung kann die Schaltspannung insbesondere in Amplitude und Pulsdauer eingestellt werden.

Gemäß einer weiteren vorteilhaften Ausgestaltung der Erfindung liegt die maximale Modulationsspannung im Bereich zwischen 800 V und 10 kV. In diesem Bereich lassen sich die meisten elektro-optischen Modulatoren und insbesondere Pockelszellen zuverlässig betreiben. Bevorzugt liegt die maximale Modulationsspannung im Bereich zwischen 800 V und 5 kV, besonders bevorzugt im Bereich zwischen 800 V und 3 kV.

Eine weitere vorteilhafte Ausgestaltung sieht einen Laser vor, der einen gepulsten Laserstrahl bereit stellt, der durch den elektro-optischen Modulator geführt wird. Erfindungsgemäß sind die Pulse des Lasers und die Pulse der Modulationsspannung aufeinander abgestimmt. Um eine pulsgenaue Modulation erreichen zu können, ist das Lasersignal, welches in dem Laser zur Erzeugung des gepulsten Laserstrahls verwendet wird, mit dem Steuersignal der Steuereinheit abgeglichen, um die gewünschte Modulation der Laserpulse zu erhalten.

Von besonderem Vorteil ist eine Ausgestaltung, bei welcher die Anstiegszeiten der Modulationsspannung kleiner sind als die Hälfte der Pausenzeit zwischen zwei Laserpulsen. Hierdurch kann die Gefahr etwaiger Fehlmodulationen deutlich verringert werden, da sich die Pausen ohne Weiteres für die Schaltvorgänge nutzen lassen. Vorteilhafterweise ist die Anstiegszeit der Modulationsspannung kleiner als ein Viertel der Pausenzeit zwischen zwei Laserpulsen, besonders bevorzugt jedoch kleiner als ein Achtel der Pausenzeit zwischen zwei Laserpulsen.

Eine in konstruktiver Hinsicht vorteilhafte da insgesamt sehr montagefreundliche Ausgestaltung sieht vor, dass der Pulserzeuger, der Spannungswandler und die Steuereinheit, insbesondere räumlich, zu einem Modul zusammengefasst sind. Auch funktional ist eine Zusammenfassung zu einem Modul denkbar. Das Modul kann innerhalb der Anordnung eine in sich geschlossene Bau- und/oder Funktionseinheit bilden. Durch das Zusammenfassen der einzelnen Komponenten zu einem Modul kann der Montageaufwand verringert werden. Zudem kann das Modul beispielsweise in einem Gehäuse angeordnet sein, wodurch die einzelnen Komponenten vor Umwelteinflüssen oder Beschädigungen geschützt werden können. Vorteilhafterweise kann das Modul aus Pulserzeuger, Spannungswandler und Steuereinheit über eine Hochspannungsleitung mit dem elektro-optischen Modulator verbunden sein, der nicht notwendigerweise Teil des Moduls sein muss.

Eine alternative Ausgestaltung sieht vor, dass der Pulserzeuger und die Steuereinheit zu einem ersten Modul sowie der Spannungswandler und der elektro-optische Modulator zu einem zweiten Modul zusammengefasst sind. Hierbei können die beiden Module über eine Niederspannungsleitung miteinander verbunden sein, wodurch sich der Vorteil ergibt, dass durch die Übertragung einer Niederspannung zwischen den zwei Modulen geringere Sicherheitsrisiken sowie Verluste bestehen.

Gemäß einer weiteren alternativen Ausgestaltung sind der Pulserzeuger, der Spannungswandler und der elektro-optische Modulator zu einem Modul zusammengefasst. Bei einem solchen Aufbau ist lediglich die Steuereinheit isoliert von dem Modul angeordnet, weshalb nur eine Signalleitung zwischen dem Modul und der Steuereinheit angeordnet werden muss. Hierdurch ergeben sich weitere Vorteile bezüglich der Sicherheit ebenso wie bezüglich der elektromagnetischen Verträglichkeit (EMV).

Eine weitere vorteilhafte Ausgestaltung der Anordnung sieht vor, dass der Pulserzeuger und/oder der Spannungswandler mittels eines Kühlkörpers, insbesondere mittels eines flüssigkeitsgekühlten Keramikträgers, kühlbar sind. Durch die Kühlung des Pulserzeugers und/oder des Spannungswandlers kann beispielsweise durch Verluste und Umladeströme entstehende Verlustwärme abgeführt werden, so dass es nicht zu einer Überhitzung und damit zu einem Ausfall der einzelnen Komponenten kommt. Vorteilhafterweise kann die für den Laser vorgesehene Laserkühlung für die Kühlung des Pulserzeugers und/oder des Spannungswandlers mit verwendet werden, wodurch sich ein einfacherer und kostengünstiger Aufbau ergibt.

Vorteilhafterweise umschließt der Kühlkörper den Pulserzeuger und/oder den Spannungswandler. Durch eine solche Ausgestaltung kann sichergestellt werden, dass die Wärme großflächig und in mehrere Richtungen abgeführt wird.

Alternativ oder zusätzlich kann der Kühlkörper auch als eine flüssigkeitsdurchströmte Platte ausgebildet sein. Dies ist insbesondere dann von Vorteil, wenn der Pulserzeuger Transistoren aufweist. Diese können bevorzugt liegend auf der Kühlplatte montiert werden, so dass eine gute Wärmeabfuhr bereits in nur einer Richtung realisiert werden kann.

Darüber hinaus wird zur Lösung der vorstehend genannten Aufgabe bei einem Verfahren der eingangs genannten Art vorgeschlagen, dass ein dem Modulator vorgeschalteter Spannungswandler eine auf einem Ausgangsspannungsniveau liegende gepulste Schaltspannung in die gegenüber dem Ausgangsspannungsniveau erhöhte Modulationsspannung wandelt.

Auch hier ergeben sich die bereits im Zusammenhang mit der Anordnung erläuterten Vorteile.

In diesem Zusammenhang ist es ferner von Vorteil, wenn zur Durchführung des Verfahrens eine Anordnung mit den zuvor beschriebenen Merkmalen verwendet wird, wobei die Merkmale der Anordnung einzeln oder in Kombination verwendet werden können.

Gemäß einer vorteilhaften Weiterbildung des Verfahrens wird vorgeschlagen, dass durch eine Veränderung der Amplitude der Schaltspannung die Amplitude der Modulationsspannung angepasst wird. Durch die Veränderung der Amplitude der bevorzugt im Niederspannungsbereich liegenden Schaltspannung kann eine präzise Puls zu Puls Variation der Schaltspannung realisiert werden, wodurch auch eine präzise Puls zu Puls Variation der bevorzugt im Hochspannungsbereich liegenden Modulationsspannung ermöglicht werden kann. Hieraus ergibt sich der Vorteil einer genaueren Modulation der Laserpulse.

Gemäß einer weiteren Ausgestaltung des Verfahrens wird ein zur Erzeugung eines gepulsten Laserstrahls verwendetes Lasersignal mit einem zur Steuerung der Steuereinheit verwendeten Steuersignal synchronisiert, so dass eine pulsgenaue Modulation der Laserpulse über die Modulationsspannung erreicht werden kann.

Vorteilhafterweise werden mit dem elektro-optischen Modulator pulsgenaue Laserpuls-Modulationsfolgen erzeugt, wodurch eine genaue Bearbeitung, Messung oder dergleichen möglich ist.

Weitere Vorteile und Einzelheiten einer erfindungsgemäßen Anordnung wie auch eines erfindungsgemäßen Verfahrens werden nachfolgend unter Zuhilfenahme der beigefügten, teilweise stark schematisierten Zeichnungen von Ausführungsbeispielen erläutert werden. Darin zeigen:
- Fig. 1: in einer blockdiagrammartigen Ansicht zunächst eine Anordnung gemäß dem Stand der Technik,
- Fig. 2: eine schematische Darstellung des Zusammenhangs zwischen Laserpulsen, Modulationsspannung und Steuerspannung gemäß dem Stand der Technik,
- Fig. 3: eine der Darstellung in Fig. 1 entsprechende Ansicht einer erfindungsgemäßen Anordnung,
- Fig. 4: eine der Darstellung in Fig. 2 entsprechende Ansicht der Laserpulse, der Modulationsspannung und der Steuerspannung einer erfindungsgemäßen Anordnung,
- Fig. 5: eine Darstellung eines Pulserzeugers,
- Fig. 6: verschiedene Ausführungsvarianten einer erfindungsgemäßen Anordnung,
- Fig. 7: eine Darstellung eines Hochspannungswandlers mit einer ersten Ausführungsvariante eines Kühlkörpers,
- Fig. 8: eine Darstellung eines Pulserzeugers mit einer zweiten Ausführungsvariante eines Kühlkörpers.

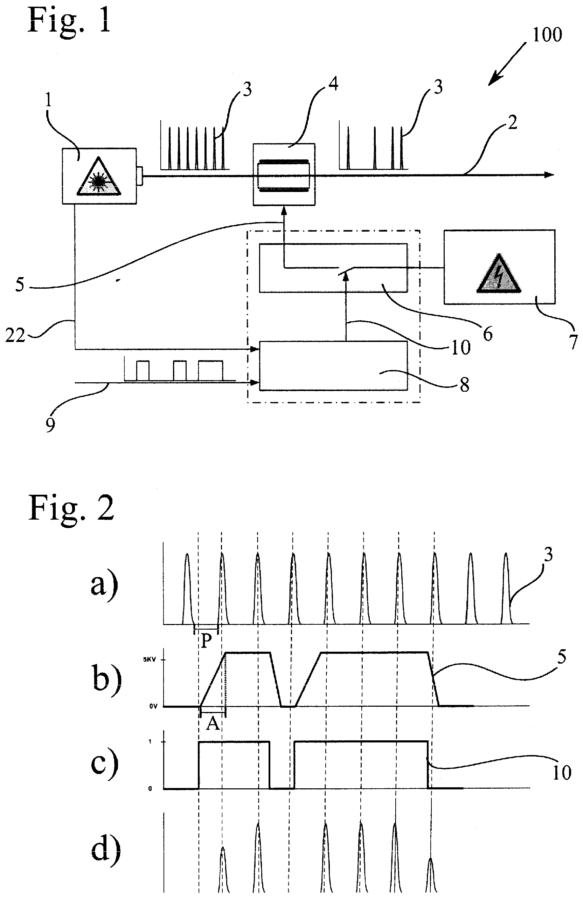

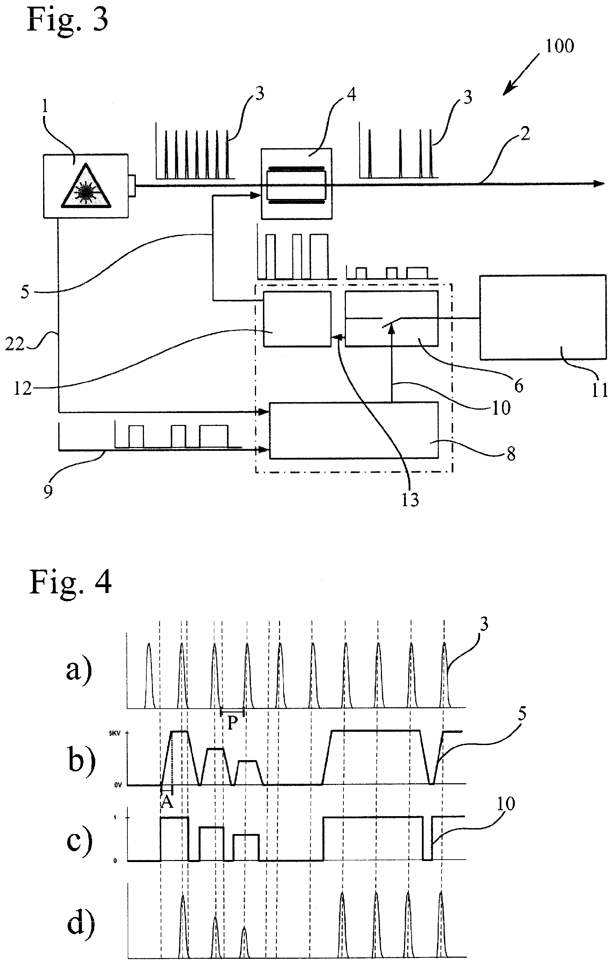

Zunächst soll anhand der Darstellung in den Fig. 1 und Fig. 2 eine aus dem Stand der Technik bekannte Anordnung 100 und auf die mit dieser verbundenen Nachteile eingegangen werden, bevor dann anhand der Darstellungen in den Fig. 3 bis 8 auf Einzelheiten der erfindungsgemäßen Anordnung 100 eingegangen werden wird.

Fig. 1 zeigt einen aus dem Stand der Technik bekannten Aufbau einer Anordnung 100 mit einem Laser 1 und einem dem Laser 1 nachgeschalteten elektro-optischen Modulator 4, welcher den von dem Laser 1 erzeugten gepulsten Laserstrahl 2 entsprechend bestimmter Modulationsvorgaben modulieren soll. Solche Anordnungen 100 werden häufig in der Materialbearbeitung, aber auch in der Messtechnik oder in der Grundlagenforschung verwendet. Denn dort muss ein gepulst bereitgestellter Laserstrahl 2 entsprechend der jeweiligen Anforderungen der Anwendung moduliert werden, wobei es häufig erforderlich ist, einzelne Pulse 3 gezielt zu modulieren.

Je nachdem für welche Anwendungen der gepulste Lasterstrahl 2 eingesetzt werden soll, ist es erforderlich, die Laserpulse 3 in ihrer Intensität zu modulieren und/oder einzelne Laserpulse 3 aus dem Laserstrahl 2 herauszulenken. Für diese Modulation ist es bekannt, elektro-optische Modulatoren 4, wie beispielsweise Pockelszellen, vorzusehen. Mit diesen Modulatoren 4 ist es möglich, die Laserpulse 3 in ihrer Polarisation, Phase und Intensität zu modulieren.

Wie dies ebenfalls der Darstellung in Fig. 1 zu entnehmen ist, wird der elektro-optische Modulator 4 in bekannten Anordnungen 100 mit einer Hochspannung betrieben, insbesondere mit einer Modulationsspannung 5. Die Modulationsspannung 5 ist dabei ebenfalls gepulst, was im Stand der Technik über einen Hochspannungsschalter 6 realisiert wird. Der Hochspannungsschalter 6 ist eingangsseitig an eine Hochspannungsquelle 7 angeschlossen, welche kontinuierliche Spannungen von 1.000 V und mehr erzeugen kann.

Nachteilig ist bei der in Fig. 1 dargestellten Anordnung 100 jedoch, dass durch die Verwendung des Hochspannungsschalters 6 ein schnelles Schalten aufgrund der bei solchen Hochspannungsschaltern 6 systembedingt vergleichsweise langen Anstiegszeiten nicht möglich ist. Vielmehr sind solche Hochspannungsschalter 6 auf Schaltfrequenzen von üblicherweise 1 MHz beschränkt.

Wie dies in Fig. 2 dargestellt ist, treten daher insbesondere beim Modulieren eher kurzpulsiger Laserstrahlen 2 häufig Probleme auf. Denn die Anstiegszeiten A der Modulationsspannung 5 sind in solchen Fällen oftmals größer als die Pausenzeit P zwischen zwei Laserpulsen 3. Die Anstiegszeit A ist dabei die Zeit, in welcher die Modulationsspannung 5 von einem ersten Spannungswert, hier von 0 V, auf einen zweiten Spannungswert, hier 5 kV, ansteigt, vgl. hierzu insbesondere Fig. 2a) und 2b).

Zwar ist es möglich, den Hochspannungsschalter 6 über eine Steuerspannung 10 (vgl. Fig. 2c) genau anzusteuern, jedoch ist der Schalter 6 aufgrund der baulichen Gegebenheiten zu träge, um ebenfalls direkt schalten zu können. Daher sind Anstiegszeiten A größer als 25 ns im Bereich der Hochspannungsschalter 6 durchaus üblich, bis die benötigte Hochspannungs-Modulationsspannung 5 erreicht ist. Infolgedessen kann es zu Fehlmodulationen kommen, bei welchen einzelne Laserpulse 3 gemäß der Darstellung in Fig. 2d) in ihrer Intensität ungewollt variiert oder ganz abgeschnitten werden. Dies kann negativen Einfluss beispielsweise auf den Bearbeitungsprozess eines Werkstücks in der Materialbearbeitung haben.

Als besonders problematisch hat sich dies bei der Verwendung von Ultrakurzpulslasersystemen, wie etwa Femtosekundenlasern, erwiesen. Denn dort wird von dem Laser 1 ein sehr hoch repetierender Laserstrahl 2 erzeugt, welcher Pulsfrequenzen von bis zu 100 MHz und darüber aufweist. Mit den bekannten Systemen lassen sich solche Laserstrahlen 2 nur sehr unzureichend modulieren. Um gute Ergebnisse zu erhalten, ist es erforderlich, Schaltfrequenzen von mehr als 1 MHz bereit zu stellen. Zusätzlich ist auch eine pulsgenaue Variation der Modulationsspannung 5 für jeden einzelnen Laserpuls 3 angestrebt, was sich mit den bekannten Hochspannungsschaltern 6 nicht realisieren lässt.

Eine erfindungsgemäße Anordnung 100, welche diese Probleme mit einfachen Mitteln löst, ist in den Fig. 3 bis 8 dargestellt und soll nachfolgend im Einzelnen erläutert werden.

Bei der erfindungsgemäßen Anordnung 100 befindet sich im Strahlweg des Lasers 1 ebenfalls der Modulator 4, welcher die Laserpulse 3 modulieren soll. Jedoch ist im Unterschied zu der in Fig. 1 dargestellten Anordnung 100 dem Modulator 4 ein Spannungswandler 12 vorgeschaltet, der eine auf einem Ausgangsspannungsniveau liegende gepulste Schaltspannung 13 in die gegenüber dem Ausgangsspannungsniveau erhöhte Modulationsspannung 5 wandelt.

Bei dem Ausführungsbeispiel liegen das Ausgangsspannungsniveau der Schaltspannung 13 im Niederspannungsbereich und das Spannungsniveau der Modulationsspannung 5 im Hochspannungsbereich. Zur begrifflichen Trennung der Spannungsniveaus werden nachfolgend die Ausdrücke Niederspannungs-Schaltspannung (LV-Schaltspannung) sowie Hochspannungs-Modulationsspannung (HV-Modulationsspannung) verwendet werden. Es sei jedoch darauf hingewiesen, dass erfindungsgemäß auch Ausgestaltungen möglich sind, bei denen die Modulationsspannung 5 ebenfalls im Niederspannungsbereich liegt, gegenüber der Schaltspannung 13 aber gleichwohl deutlich erhöht ist.

Durch den dem Modulator 4 vorgeschalteten Spannungswandler 12, welcher die im Niederspannungsbereich liegende Schaltspannung 13 in die erhöhte, bevorzugt im Hochspannungsbereich liegende Modulationsspannung 5 wandelt, ist es möglich, bereits im Niederspannungsbereich eine gepulste LV-Schaltspannung 13 entsprechend der Modulationsvorgabe zu erzeugen, welche dann mit Hilfe des Hochspannungswandlers 12 unter Beibehaltung der Pulsfolge in die HV-Modulationsspannung 5 gewandelt wird.

Der Spannungswandler 12 ist in diesem Ausführungsbeispiel als ein als Hochspannungswandler ausgebildeter Transformator ausgebildet, welcher zur Verbesserung dessen physikalischer Eigenschaften und zur Erhöhung des Wirkungsgrades einen Ferritkern 20 aufweist. Auch ist es möglich, den Transformator 12 als Platinentransformator auszuführen, wobei die Windungen als Platine ausgebildet sind. An den Transformator 12 wird primärseitig die LV-Schaltspannung 13 angelegt, wobei mittels des Transformators 12 dann entsprechend eines vordefinierten Wicklungsverhältnisses die LV-Schaltspannung 13 sekundärseitig in die HV-Modulationsspannung 5 transformiert wird. Mit dieser wird dann der Modulator 4 beaufschlagt.

Wie dies bereits zum Stand der Technik erläutert wurde, muss der Modulator 4 mit einer gepulsten HV-Modulationsspannung 5 beaufschlagt werden, die an die Pulsfolge des Laserstrahls 2 angepasst ist. Erfindungsgemäß wird diese Pulsung im Niederspannungsbereich erzeugt. Hierzu ist ein Pulserzeuger 6 vorgesehen, welcher die von einer Niederspannungsquelle 11 kontinuierlich bereitgestellte Niederspannung entsprechend den Modulationsvorgaben pulst.

Die Niederspannungsquelle 11 ist dem Pulserzeuger 6 vorgeschaltet und stellt eine Spannung im Bereich von 10 V bis 1.000 V, jedoch besonders bevorzugt von 100 V, zur Verfügung. Durch die Verwendung einer Niederspannung auf der Primärseite des Transformators 12 können Niederspannungsbauteile verwendet werden. Bei diesen handelt es sich zumeist um Standardbauteile, welche in großen Stückzahlen zur Verfügung stehen und daher einfach beschafft werden können. Auch sind die Überschlagsgefahr sowie die mit der Verwendung von Hochspannungsbauteilen verbundenen elektromagnetischen Belastungen deutlich geringer. Der größte Vorteil dieser Bauteile liegt jedoch darin, dass sich sehr kurze Anstiegszeiten A ergeben.

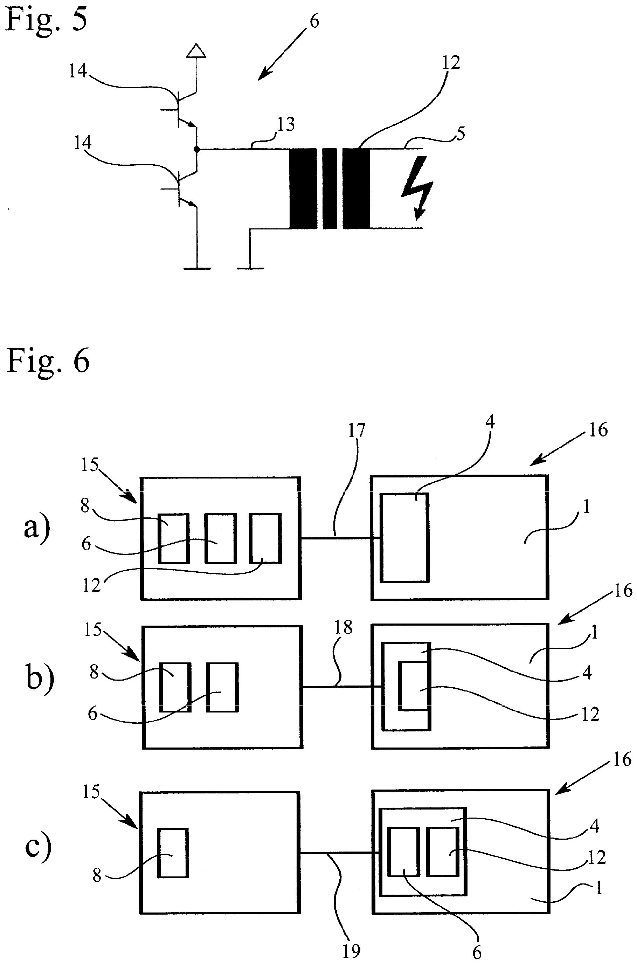

Der Pulserzeuger 6 ist als ein Schalter ausgebildet, welcher die von der Niederspannungsquelle 11 erzeugte Niederspannung je nach Modulationsvorgabe ein- und ausschalten kann. In dem vorliegenden Ausführungsbeispiel sind die Schaltelemente als Halbleiter- bzw. Transistorkaskade aus einzelnen Halbleiterbauteilen 14, wie Transistoren oder aus mehreren parallelgeschalteten Halbleiterbauteilen 14 ausgebildet und als Transistor-Halbbrücke verschaltet. Eine schematische Darstellung einer solchen Transistor-Halbbrücke als Pulserzeuger 6 zeigt Fig. 5. Alternativ ist jedoch auch die Verwendung einer Transistor-Vollbrücke möglich.

Die Verwendung von Transistoren 14 und insbesondere von MOSFETs bietet den Vorteil kurzer Anstiegszeiten A, so dass ein schnelles Schalten im Niederspannungsbereich möglich ist. Auch bei der Verwendung von Ultrakurzpulslasersystemen ist daher eine genaue Puls-zu-Puls Modulation der Laserpulse 3 möglich. Durch die Verwendung von Transistor-Halb- oder-Vollbrücken treten während des Umschaltens zwischen einer ersten und zweiten Spannung geringere Schaltverluste auf. Auch werden die durch hohe Umladeströme erzeugten Wärmeverluste gering gehalten.

Wie dies ebenfalls der Fig. 5 zu entnehmen ist, ist die Transistorkaskade, bestehend aus den beiden Transistoren 14 primärseitig mit dem Transformator 12 verbunden, welcher die gepulste LV-Schaltspannung 13 sekundärseitig in die HV-Modulationsspannung 5 wandelt.

Damit der Pulserzeuger 6 die gepulste LV-Schaltspannung 13 erzeugen kann, ist es erforderlich, diesen entsprechend der Modulationsvorgaben mit einer Steuerspannung 10 zu beaufschlagen, vgl. Fig. 3. Auch die Steuerspannung 10 ist daher entsprechend der Modulationsvorgaben gepulst.

Bereitgestellt wird die Steuerspannung 10 über eine Steuereinheit 8. Die Steuereinheit 8 kann beispielsweise mit einem Computer o. ä. verbunden sein, von welchem aus ein Steuersignal 9, welches ein vorgegebener Bitstrom sein kann, an die Steuereinheit 8 gesendet wird. Das Steuersignal 9 stellt die eigentliche Modulationsvorgabe dar, die auch von der Steuerspannung 10, der Schaltspannung 13 bis hin zur Modulationsspannung 5 erhalten bleibt. Die Steuerspannung 10 wird mit Hilfe des Steuersignals 9 moduliert und als Schaltvorgabe dem Pulserzeuger 6 zugeführt, so dass die LV-Schaltspannung 13 entsprechend der Modulationsvorgabe gepulst ist. Durch die Verwendung eines LV-Pulserzeugers 6 ergibt sich der Vorteil, dass die Steuerspannung 10 auf einem deutlich geringeren Spannungsniveau liegen kann, als dies beispielsweise beim Hochspannungsschalter aus dem Stand der Technik der Fall wäre. Es ergibt sich daher ein einfacher und kostengünstiger Aufbau.

Nachfolgend sollen nun anhand der Darstellungen in der Fig. 4 die sich ergebenen Vorteile einer erfindungsgemäßen Anordnung 100 genauer erläutert werden. Durch die Verwendung von Niederspannungsbauteilen werden die Anstiegszeiten A der HV-Modulationsspannung 5 gegenüber dem Stand der Technik deutlich verkürzt. So können Anstiegszeiten A erreicht werden, welche kleiner sind als die Hälfte der Pausenzeit P zwischen zwei Pulsen 3. Um nun Laserpulse 3 von Ultrakurzpulslasersystemen genau modulieren zu können, sind Anstiegszeiten A kleiner als P/2 von Vorteil, besonders vorteilhaft ist es jedoch, wenn diese kleiner sind als P/4 und insbesondere als P/8 sind. Eine entsprechende Darstellung der HV-Modulationsspannung 5 einer erfindungsgemäßen Anordnung 100 ist in Fig. 4b) gezeigt.

Da die Anstiegszeiten A der HV-Modulationsspannung 5 geringer sind als die Pausenzeit P zwischen zwei Laserpulsen 3 wird Fehlmodulationen vorgebeugt. Denn so ist es möglich, die Schaltvorgänge mit einer gewissen Sicherheit bzw. Toleranz innerhalb der zeitlich längeren Pausenzeit P unterzubringen. Im Ergebnis kommt es nicht mehr zu ungewollten Abschneidungen von einzelnen Laserpulsen 3 oder zu einer ungewollten Veränderung der Intensität der Laserpulse 3. Fehlmodulationen wird zuverlässig vorgebeugt. So ist beispielsweise das Erzeugen von präzisen Graustufen-Bitmaps möglich.

Wird die Amplitude der Steuerspannung 10 und damit auch die Amplitude der LV-Schaltspannung 13 variiert, setzt sich dies auch in der HV-Modulationsspannung 5 fort. Wie dies der Darstellung der Fig. 4b) zu entnehmen ist, kann die HV-Modulationsspannung 5 beispielsweise von einem Spannungswert von 5 kV auf 3 kV oder 2 kV reduziert werden, was dann wiederum zu einer Verringerung der Intensität der Laserpulse 3, wie dies in der Fig. 4d) gezeigt ist, führt.

Ein Lasersignal 22, welches von dem Laser 1 zur Erzeugung des gepulsten Laserstrahls 2 verwendet wird, ist mit dem Steuersignal 9 bzw. mit der Steuerspannung 10 synchronisiert. Denn so ist ein zeitlicher Phasenangleich zwischen den Laserpulsen 3 und dem als Modulationsvorgabe dienenden Steuersignal 9 auf einfache Art und Weise möglich. Aufwändige Variationen der einzelnen Phasenlagen sind nicht erforderlich.

Anhand der Darstellungen in den Fig. 6a) - 6c) sollen nun mögliche Modulbauweisen der einzelnen Elemente der Anordnung 100 erläutert werden, wobei unter dem Begriff Modul nachfolgend räumliche und/oder funktionelle Einheiten verstanden werden sollen.

Die Fig. 6a zeigt eine Anordnung, bei welcher der Hochspannungswandler 12, der Pulserzeuger 6 und die Steuereinheit 8 zu einem Modul 15 zusammengefasst sind. Das Modul 15 ist über eine Hochspannungsleitung 17 mit dem Laser 1, an welchem auch der Modulator 4 angeordnet ist, verbunden. Der Laser 1 und der Modulator 4 bilden ebenfalls ein gemeinsames Modul 16.

In Fig. 6b) ist eine Ausführung dargestellt, bei der der Pulserzeuger 6 und die Steuereinheit 8 zu einem Modul 15 zusammengefasst sind. Der Hochspannungswandler 12 ist hingegen am Modulator 4 angeordnet, wodurch sich ein Hochspannungsmodul 16 ergibt. Da die Hochspannungswandlung erst im Modul 16 stattfindet, kann das Modul 15 über eine Niederspannungsleitung 18 mit dem Modul 16 verbunden werden, weshalb sich hier der Aufwand für die Verkabelung reduziert. Es ergibt sich eine günstige Aufteilung in ein LV-Modul 15 und ein HV-Modul 16.

Fig. 6c) zeigt eine dritte Ausführungsvariante, bei welcher ebenfalls ein LV-Modul 15 und ein HV-Modul 16 vorgesehen sind. Sowohl der Pulserzeuger 6, der Hochspannungswandler 12 als auch der elektro-optische Modulator 4 befinden sich in dem Modul 16. Daher ist es nur erforderlich, die Steuereinheit 8, welche in dem Modul 15 angeordnet ist, über eine Signalleitung 19 mit dem Modul 16 zu verbinden, was den Aufbau der Anordnung und insbesondere deren Verkabelung weiter vereinfacht.

Durch das Anordnen einzelner oder mehrerer Komponenten am Modulator 4 bzw. am Laser 1 werden die Leitungsanforderungen zwischen den einzelnen Modulen 15, 16 vereinfacht. So kann auf eine in Fig. 6a) dargestellte Hochspannungsleitung 17 bzw. sogar auf eine in Fig. 6b) dargestellte Niederspannungsleitung 18 verzichtet werden. Der Schritt von einer Hochspannungsleitung 17 hin zu einer Niederspannungsleitung 18 ist bereits von großem Vorteil, da die Gefahr von Überschlägen aber auch die Anforderungen an die Sicherheit einer solchen Anordnung 100 verringert werden können. Durch den Schritt von einer Niederspannungsleitung 18 hin zu einer Signalleitung 19, wird die Anordnung 100 weiter vereinfacht und kostengünstiger ausgestaltet. Auch die EMV-Beeinträchtigungen werden dadurch weiter deutlich verringert.

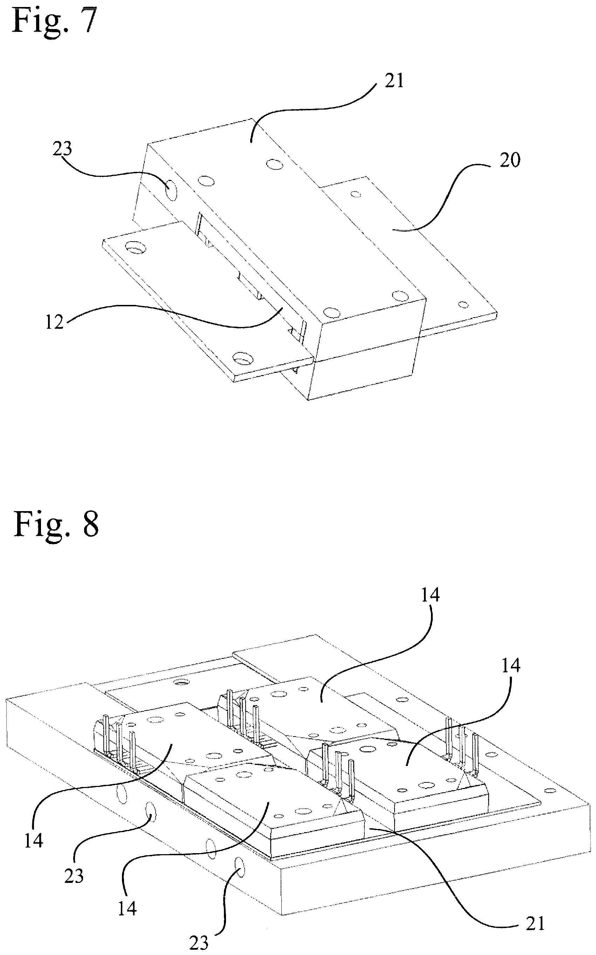

Da aufgrund der hohen Umladeströme bei der Pulserzeugung, aber auch bei der Transformation der LV-Schaltspannung 13, Verlustwärme entsteht, ist es erforderlich, den Pulserzeuger 6 und/oder den Hochspannungswandler 12 zu kühlen. Hierzu ist gemäß den Darstellungen in den Fig. 7 und 8 ein Kühlkörper 21 und insbesondere ein flüssigkeitsgekühlter Keramikkühlkörper vorgesehen. Keramik bietet Vorteile, da diese die elektrischen Eigenschaften der Anordnung nicht beeinträchtigt. Als vorteilhaftes Material hat sich beispielsweise eine Aluminium-Nitrit-Keramik bewährt.

Wie dies der Darstellung in Fig. 7 zu entnehmen ist, sieht eine erste Ausführung vor, dass sich der Transformator 12 im Inneren eines jochförmigen Kühlkörpers 21 befindet. Im Inneren des Transformators 12 ist dessen Ferritkern 20 angeordnet. Wie dies der Darstellung in Fig. 7 weiter zu entnehmen ist, weist der Kühlkörper 21 Öffnungen 23 auf, die den Wasserdurchlauf durch den Kühlkörper 21 ermöglichen. Dadurch, dass der Kühlkörper 21 den Transformator 12 vollständig umschließt, kann eine großflächige Wärmeabfuhr in mehrere Richtungen erreicht werden. Es kommt infolgedessen nicht zu einer Überhitzung der Bauelemente und somit auch nicht zu einem Ausfall der Anordnung 100.

Fig. 8 zeigt eine alternative Ausführung des Kühlkörpers 21, bei welchem die Transistoren 14, welche als Pulserzeuger 6 verwendet werden, auf einer ebenfalls flüssigkeitsgekühlten Keramikplatte 21 angeordnet sind. Wie dies die Darstellung zeigt, liegen die Transistoren 14 flächig auf der Keramikplatte 21 auf, so dass eine große Fläche der Transistoren 14 gekühlt werden kann. Auch hier dienen die Öffnungen 23 der Wasserzufuhr und Wasserabfuhr. Durch eine solche Ausgestaltung kann die Wärmeabfuhr nach unten hin erfolgen.

Ist an dem Laser 1 bzw. an dem Modulator 4 bereits ein Kühlsystem vorgesehen, kann dieses auch für die Kühlung des Hochspannungswandlers 12 bzw. des Pulserzeugers 6 verwendet werden. Hierdurch entsteht ein einfacher, kostengünstiger Aufbau.

Die vorstehend beschriebene Anordnung 100, wie auch das entsprechende Verfahren, zeichnen sich dadurch aus, dass eine auf einem Ausgangsspannungsniveau liegende gepulste Schaltspannung 13 im Niederspannungsbereich erzeugt werden kann, welche dann über einen Spannungswandler 12 in die erforderliche auf einem gegenüber dem Ausgangsspannungsniveau erhöhte Modulationsspannung 5 gewandelt werden kann, so dass entsprechend den Modulationsvorgaben Laserpulse 3 moduliert werden können.

### Bezugszeichen:

- 1: Laser
- 2: Laserstrahl
- 3: Laserpuls
- 4: Elektro-optischer Modulator
- 5: Modulationsspannung
- 6: Pulserzeuger
- 7: Hochspannungsquelle
- 8: Steuereinheit
- 9: Steuersignal
- 10: Steuerspannung
- 11: Niederspannungsquelle
- 12: Spannungswandler
- 13: Schaltspannung
- 14: Halbleiterbauteil
- 15: Modul
- 16: Modul
- 17: Hochspannungsleitung
- 18: Niederspannungsleitung
- 19: Signalleitung
- 20: Ferritkern
- 21: Kühlkörper
- 22: Lasersignal
- 23: Öffnung
- 100: Anordnung

- P: Pausenzeit
- A: Anstiegszeit

## Patentansprüche

1. Anordnung zum Modulieren von Laserpulsen (3), die von einem Laser (1) erzeugt werden, mit einem elektro-optischen Modulator (4), der über eine gepulste Modulationsspannung (5) betrieben wird, mit einem dem Modulator (4) vorgeschalteten Spannungswandler (12), der eine auf einem Ausgangsspannungsniveau liegende gepulste Schaltspannung (13) in die gegenüber dem Ausgangsspannungsniveau erhöhte Modulationsspannung (5) wandelt, wobei dem Spannungswandler (12) ein Pulserzeuger (6) vorgeschaltet ist, der über eine von einer Steuereinheit (8) erzeugte Steuerspannung (10) ansteuerbar ist,
wobei ein zur Erzeugung der Laserpulse (3) verwendetes Lasersignal (22) mit einem zur Steuerung der Steuereinheit (8) verwendeten Steuersignal (9) synchronisierbar ist und
wobei der Spannungswandler (12) und der Pulserzeuger (6) so konfiguriert sind, dass Anstiegszeiten (A) der Modulationsspannung (5) geringer sind als die Pausenzeit (P) zwischen zwei Laserpulsen (3), so dass Schaltvorgänge in der Pausenzeit (P) unterbringbar sind.

2. Anordnung nach Anspruch 1, **dadurch gekennzeichnet, dass** der Pulserzeuger (6) als Schalter, insbesondere als Halbleiter-Schalter, ausgebildet ist.

3. Anordnung nach einem der Ansprüche 1 oder 2, **dadurch gekennzeichnet, dass** der Pulserzeuger (6) als Halbleiter-Halbbrücke oder Halbleiter-Vollbrücke ausgebildet ist.

4. Anordnung nach einem der Ansprüche 1 bis 3, **dadurch gekennzeichnet, dass** dem Pulserzeuger (6) eine Niederspannungsquelle (11) vorgeschaltet ist.

5. Anordnung nach einem der vorhergehenden Ansprüche, **gekennzeichnet durch** einen Laser (1), der einen gepulsten Laserstrahl (2) bereit stellt, der durch den elektro-optischen Modulator (4) geführt wird.

6. Anordnung nach Anspruch 5, **dadurch gekennzeichnet, dass** die Anstiegszeiten (A) der Modulationsspannung (5) kleiner sind als die Hälfte der Pausenzeit (P) zwischen zwei Laserpulsen (3).

7. Anordnung nach einem der vorhergehenden Ansprüche, **dadurch gekennzeichnet, dass** der Pulserzeuger (6) und/oder der Spannungswandler (12) mittels eines Kühlkörpers (21), insbesondere mittels eines flüssigkeitsgekühlten Keramikträgers, kühlbar ist.

8. Anordnung nach Anspruch 7, **dadurch gekennzeichnet, dass** der Kühlkörper (21) den Pulserzeuger (6) und/oder den Spannungswandler (12) umschließt.

9. Anordnung nach Anspruch 7, **dadurch gekennzeichnet, dass** der Kühlkörper (21) als flüssigkeitsdurchströmte Platte ausgebildet ist.

10. Verfahren zum Modulieren von Laserpulsen (3), die von einem Laser (1) erzeugt werden, mit einem elektrooptischen Modulator (4), der über eine gepulste Modulationsspannung (5) betrieben wird, wobei ein dem Modulator (4) vorgeschalteter Spannungswandler (12) eine auf einem Ausgangsspannungsniveau liegende gepulste Schaltspannung (13) in die gegenüber dem Ausgangsspannungsniveau erhöhte Modulationsspannung (5) wandelt,
wobei dem Spannungswandler (12) ein Pulserzeuger (6) vorgeschaltet ist, der über eine von einer Steuereinheit (8) erzeugte Steuerspannung (10) angesteuert wird, ein zur Erzeugung der Laserpulse (3) verwendetes Lasersignal (22) mit einem zur Steuerung der Steuereinheit (8) verwendeten Steuersignal (9) synchronisiert wird und wobei d
er Spannungswandler (12) und der Pulserzeuger (6) so konfiguriert sind, dass Anstiegszeiten (A) der Modulationsspannung (5) geringer sind als die Pausenzeit (P) zwischen zwei Laserpulsen (3), so dass Schaltvorgänge in der Pausenzeit (P) untergebracht werden können.

11. Verfahren nach Anspruch 10, **dadurch gekennzeichnet, dass** zur Durchführung des Verfahrens eine Anordnung nach einem der Ansprüche 1 bis 9 verwendet wird.

12. Verfahren nach einem der Ansprüche 10 oder 11, **dadurch gekennzeichnet, dass** durch eine Veränderung der Amplitude der Schaltspannung (13) die Amplitude der Modulationsspannung (5) angepasst wird.

## Claims

1. Arrangement for modulating laser pulses (3), which are generated by a laser (1), with an electro-optical modulator (4) which is operated by means of a pulsed modulation voltage (5), with a voltage converter (12) which is connected upstream of the modulator (4) and converts a pulsed switching voltage (13) at an output voltage level into the modulation voltage (5) which is increased relative to the output voltage level, wherein a pulse generator (6) is connected upstream of the voltage converter (12) and can be controlled via a control voltage (10) generated by a control unit (8), wherein a laser signal (22) used for generating the laser pulses (3) can be synchronized with a control signal (9) used for controlling the control unit (8), and wherein the voltage converter (12) and the pulse generator (6) are configured in such a manner that rise times (A) of the modulation voltage (5) are less than the pause time (P) between two laser pulses (3), with the result that switching operations can be accommodated in the pause time (P).

2. Arrangement according to Claim 1, **characterized in that** the pulse generator (6) is embodied as a switch, in particular as a semiconductor switch.

3. Arrangement according to either of Claims 1 and 2, **characterized in that** the pulse generator (6) is embodied as a semiconductor half-bridge or semiconductor full-bridge.

4. Arrangement according to any of Claims 1 to 3, **characterized in that** a low voltage source (11) is connected upstream of the pulse generator (6).

5. Arrangement according to any of the preceding claims, **characterized by** a laser (1) which provides a pulsed laser beam (2) which is passed through the electro-optical modulator (4).

6. Arrangement according to Claim 5, **characterized in that** the rise times (A) of the modulation voltage (5) are less than half of the pause time (P) between two laser pulses (3).

7. Arrangement according to any of the preceding claims, **characterized in that** the pulse generator (6) and/or the voltage converter (12) are/is coolable by means of a heat sink (21), in particular by means of a liquid-cooled ceramic carrier.

8. Arrangement according to Claim 7, **characterized in that** the heat sink (21) encloses the pulse generator (6) and/or the voltage converter (12).

9. Arrangement according to Claim 7, **characterized in that** the heat sink (21) is embodied as a plate through which liquid flows.

10. Method for modulating laser pulses (3), which are generated by a laser (1), with an electro-optical modulator (4) which is operated by means of a pulsed modulation voltage (5), wherein a voltage converter (12) connected upstream of the modulator (4) converts a pulsed switching voltage (13) at an output voltage level into the modulation voltage (5) which is increased relative to the output voltage level, wherein a pulse generator (6) is connected upstream of the voltage converter (12) and is controlled via a control voltage (10) generated by a control unit (8), a laser signal (22) used for generating the laser pulses (3) is synchronized with a control signal (9) used for controlling the control unit (8), and wherein the voltage converter (12) and the pulse generator (6) are configured in such a manner that rise times (A) of the modulation voltage (5) are less than the pause time (P) between two laser pulses (3), with the result that switching operations can be accommodated in the pause time (P).

11. Method according to Claim 10, **characterized in that** an arrangement according to any of Claims 1 to 9 is used for carrying out the method.

12. Method according to either of Claims 10 and 11, **characterized in that** the amplitude of the modulation voltage (5) is adapted by varying the amplitude of the switching voltage (13).

## Revendications

1. Ensemble pour la modulation d'impulsions laser (3) produites par un laser (1), l'ensemble présentant un modulateur électro-optique (4) alimenté par une tension de modulation (5) pulsée, un convertisseur de tension (12) raccordé en amont du modulateur (4) et convertissant une tension de commutation (13) pulsée située à un niveau de tension de sortie en une tension de modulation (5) plus élevée que le niveau de tension de sortie, un générateur (6) d'impulsions étant raccordé en amont du convertisseur de tension (12) et pouvant être commandé par une tension de commande (10) produite par une unité de commande (8), un signal laser (22) utilisé pour former les impulsions laser (3) pouvant être synchronisé par rapport à un signal de commande (9) utilisé pour la commande de l'unité de commande (8), le convertisseur de tension (12) et le générateur (6) d'impulsions étant configurés de telle sorte que la durée de montée (A) de la tension de modulation (5) soit plus courte que la durée des pauses (P) entre deux impulsions laser (3), de manière que des opérations de commutation puissent être intercalées pendant les pauses (P).

2. Ensemble selon la revendication 1, **caractérisé en ce que** le générateur (6) d'impulsions est configuré comme commutateur et notamment comme commutateur semiconducteur.

3. Ensemble selon l'une des revendications 1 et 2, **caractérisé en ce que** le générateur (6) d'impulsions est configuré comme demi-pont semiconducteur ou comme pont semiconducteur complet.

4. Ensemble selon l'une des revendications 1 à 3, **caractérisé en ce qu'**une source (11) de basse tension est raccordée en amont du générateur (6) d'impulsions.

5. Ensemble selon l'une des revendications précédentes, **caractérisé par** un laser (1) qui délivre un faisceau laser (2) pulsé guidé par le modulateur électro-optique (4).

6. Ensemble selon la revendication 5, **caractérisé en ce que** la durée de montée (A) de la tension de modulation (5) est plus courte que la moitié de la durée des pauses (P) entre deux impulsions laser (3).

7. Ensemble selon l'une des revendications précédentes, **caractérisé en ce que** le générateur (6) d'impulsions et/ou le convertisseur de tension (12) peuvent être refroidis au moyen d'un corps de refroidissement (21) et notamment au moyen d'un support en céramique refroidi par un liquide.

8. Ensemble selon la revendication 7, **caractérisé en ce que** le corps de refroidissement (21) englobe le générateur (6) d'impulsions et/ou le convertisseur de tension (12).

9. Ensemble selon la revendication 7, **caractérisé en ce que** le corps de refroidissement (21) est configuré comme plaque traversée par un liquide.

10. Procédé pour la modulation d'impulsions laser (3) produites par un laser (1), l'ensemble présentant un modulateur électro-optique (4) alimenté par une tension de modulation (5) pulsée, un convertisseur de tension (12) raccordé en amont du modulateur (4) et convertissant une tension de commutation (13) pulsée située à un niveau de tension de sortie en une tension de modulation (5) plus élevée que le niveau de tension de sortie, un générateur (6) d'impulsions étant raccordé en amont du convertisseur de tension (12) et étant commandé par une tension de commande (10) produite par une unité de commande (8), un signal laser (22) utilisé pour former les impulsions laser (3) étant synchronisé par rapport à un signal de commande (9) utilisé pour la commande de l'unité de commande (8), le convertisseur de tension (12) et le générateur (6) d'impulsions étant configurés de telle sorte que la durée de montée (A) de la tension de modulation (5) soit plus courte que la durée des pauses (P) entre deux impulsions laser (3), de manière que des opérations de commutation puissent être intercalées pendant les pauses (P).

11. Procédé selon la revendication 10, **caractérisé en ce qu'**un ensemble selon l'une des revendications 1 à 9 est utilisé pour mettre en oeuvre le procédé.

12. Procédé selon l'une des revendications 10 ou 11, **caractérisé en ce que** l'amplitude de la tension de modulation (5) est adaptée par modification de l'amplitude de la tension de commutation (13).
